# EUROPEAN PATENT SPECIFICATION

(11) **EP 2 671 088 B1**
(45) Date of publication and mention of the grant of the patent: **08.08.2018**
(21) Application number: 12708762.5
(22) Date of filing: 31.01.2012
(51) Int. Cl.: G01R 15/18

(54) **DEVICE AND METHOD FOR MEASURING AN ALTERNATING VOLTAGE**
VORRICHTUNG UND VERFAHREN ZUR MESSUNG EINER WECHSELSPANNUNG
DISPOSITIF ET PROCÉDÉ DE MESURE D'UNE TENSION ALTERNATIVE

(30) Priority: 31.01.2011 IT UD20110012
(43) Date of publication of application: 11.12.2013
(73) Proprietor: ELIWELL CONTROLS SRL CON UNICO SOCIO, 32010 PIEVE D'ALPAGO (BL) (IT)
(72) Inventor: PATURZO, Antonio, I-32015 Puos D'Alpago (IT)
(74) Representative: Petraz, Gilberto Luigi
(86) International application number: PCT/EP2012/051491
(87) International publication number: WO 2012/104270

(56) References cited:
- EP-A2- 2 169 798
- DE-A1- 4 413 028
- DE-A1- 19 802 831
- DE-A1-102007 041 176
- DE-A1-102009 050 806
- US-A- 5 546 331
- US-A1- 2008 215 278
- US-B1- 6 604 055

## Description

### FIELD OF THE INVENTION

The present invention concerns a device, and the relative method, for measuring alternating voltage for electric mains lines.

### BACKGROUND OF THE INVENTION

Devices are known for measuring the voltage in electric mains lines with alternating voltage. In some applications, such devices use measuring transformers to convert alternating mains voltage into a lower alternating voltage, so as to guarantee the galvanic insulation of the measuring instrument itself from the electric mains, and obtain a voltage usable by common measuring circuits.

Using a transformer to obtain a galvanic insulation prevents dangerous situations that may occur if the instrument were to be connected to external devices, for example probes of various types.

One disadvantage of this technique, however, is that the measuring transformers are very expensive and bulky.

One solution to solve these disadvantages, at least partly, is to make an instrument for measuring voltage that measures its own alternating mains voltage, using a transformer already present on the measuring instrument itself, with a supply function. Using its own pre-existing transformer connected to the line, the risks relating to the connection of the instruments to external devices are avoided, particularly if the measuring instrument also performs supplementary functions, for example control functions, and requires various other connections. Furthermore, savings are made on the costs relating to the measuring transformer, which no longer has to be present inside the device, thus making the apparatus compact and light.

In particular, the secondary winding of the pre-existing supply transformer may be used simultaneously to measure the voltage and to supply the measuring and control circuits.

One disadvantage of using a pre-existing transformer and of measuring directly the DC voltage generated by the supply stage is due to the fact that the measurement of the voltage obtained is not reliable, because it depends, in a strongly non-linear manner, on electrical quantities of the measuring circuit itself. In particular, the measurement of the voltage depends non-linearly on the absorption of the instrument itself which, if it performs supplementary functions, can be extremely variable, for example based on the number and type of relays activated if the instrument controls external loads. Furthermore, the measurement may depend on other environmental factors, such as temperature and/or humidity or other.

The US patent US-A-5,546,331 describes a circuit for measuring an alternating source which provides to use coefficients to correct the calculation of the voltage. This measuring method is too imprecise for the purposes of the present invention, and does not take into account the non-linearity introduced by some environmental variables such as, for example, the working temperature; it also requires long calibration times to estimate reliable coefficients, since these depend on the real values of the circuit components.

The German patent DE 4413028 A1 (DE'028) discloses a device able to measure the current absorbed by a load by means of a current measuring transformer having the double function of measuring current and supplying the measuring instrument. In DE'028 there are two distinct rectifiers, a full-wave rectifier to generate the supply voltage and a half-wave rectifier with a measuring function. The adoption alone of the indications made in DE'028 does not completely free the measurement signal and its evaluation from the effects of the load, since there are no indications of particular processing made on the measurement signal which, in the periods when the rectifier associated with the supply stage is conducting, reflects a strong dependence on the load effects. This dependence on the load effects does not allow to obtain precise measurements compatible with the applications to which the present invention applies.

The German patent DE 102009050806 A1 (DE'806) describes, as in DE'028, a device able to measure the current absorbed by a load by means of a current measuring transformer having the double function of measuring current and supplying the measuring instrument. This document makes a synthetic mention of the adoption of the choice to separate the positive half-waves of the signal on the secondary winding of the current transformer with the purpose of generating the supply voltage and separating the negative half-waves to which the measuring function is associated. DE'806 does not discuss in detail the reasons which lead to this choice, the load effects on the measuring transformer are not described and the modes for processing the signal corresponding to the negative half-wave are not illustrated. No mention is made regarding the possible effects of magnetic hysteresis associable with the core of the transformer. The application of the technique illustrated in DE'806 to measuring a current, even if transferred to a measurement of voltage, would in no way allow to make the precise measurements required by the applications to which the present invention refers, since DE'806 does not deal with the problem of the degeneration of the precision measurement due to phenomena of magnetic hysteresis in the core of the transformer. Other such art is found in EP2169798. It is only proper to underline here that both the prior art documents indicated above refer to devices able to measure currents, not voltages. Adopting a single transformer with a supply and measuring functions entails substantially different load effects between measuring a voltage and measuring a current: in order to obtain very precise measurements, since said load effects have to be considered together with non-ideal phenomena of the transformer, such as the impedance of the windings and the hysteresis phenomena in the core of the transformer, they do not allow an immediate transposition of the techniques of measuring current to dual techniques for measuring voltage.

We must also underline that the two cited prior art documents use a current transformer that intrinsically has high linearity and negligible hysteresis phenomena, since it is a measuring transformer. They therefore use a measuring transformer not only for the natural function of measuring the current but also for the supply function. The applications to which the present invention are applied are opposite, and much more complicated.

Indeed, the field of the present invention concerns the use of a pre-existing supply voltage transformer, with few characteristics of linearity and with considerable magnetic hysteresis phenomena, not only for its natural supply function but also to perform the function of measuring the voltage with extremely high precision.

Purpose of the present invention is therefore to obtain a device for measuring voltages that is insulated, economical and simple to be manufactured, which can carry out an extremely reliable measurement of the voltage without requiring a dedicated measuring transformer, but using a common supply voltage transformer, also able to supply the measuring device itself.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purposes, the measuring device according to the present invention is suitable to measure a sinusoidal alternating voltage of an electric mains line, guaranteeing a galvanic insulation of its operating circuits with respect to the latter.

The measuring device according to the present invention comprises a measuring circuit, a supply circuit that supplies the measuring circuit, and a transformer, inside or outside the container of the measuring device, with a supply function. The supply transformer has its primary winding connected to the electric mains on which the measurement has to be carried out. The transformer also has its secondary winding connected to the measuring circuit and the supply circuit.

According to a first form of embodiment of the present invention, the supply circuit comprises a first element suitable to convert the alternating voltage of the secondary winding into a full-wave rectified voltage, and the measuring circuit comprises a second element, also suitable to convert the alternating voltage of the secondary winding into a full-wave rectified voltage. A resistive type load with high impedance is connected to the second element.

According to one form of embodiment of the present invention, the first and second elements are diode bridges.

The measuring circuit also comprises a microcontroller, suitable to measure the alternating voltage present on the secondary winding of the transformer. The microcontroller is configured to extrapolate the rectified sinusoidal waveform, sampling the full-wave waveform derived from the second diodes bridge rectifier.

The sampled signal is evaluated at time intervals across the instants where the measuring voltage vanishes, in which, for measuring purposes, the distortion due to the load of the supply circuit is negligible, since the first element of the supply circuit is in a non-conducting state in said time intervals.

According to this first form of embodiment, therefore, the two elements are suitable to make the waveform of the voltage of the measuring circuit substantially independent, at least for certain time intervals, from the waveform of the voltage of the supply circuit, so that the voltage present in the measuring circuit in said time intervals is proportional to the alternating voltage of the mains line to be measured.

In general, the non-conducting intervals of the first rectifier element, intrinsically related to its working in conjunction with the smoothing capacitor, have a temporal extension dependent in a non-linear manner on the load absorption of the supply circuit, and include the time instant where the voltage sampled by the microcontroller vanishes.

Non-conducting intervals of the first rectifier element, independent of the load of the supply circuit, are determined and fixed according to the evaluation of the intersection between the non-conducting intervals of the first rectifier element, which generally depend on the load, as the values assumed by said load vary.

The intersection is not empty and has a non-zero extension, since each of the non-conducting intervals dependent on the load to be intersected has a non-zero extension and since each of the non-conducting intervals depending on the load contains the instant when the voltage sampled vanishes.

The non-conducting intervals independent of the load, according to the invention, can be parameterized in a non-volatile memory of the microcontroller and referred to the zero-crossing of the sampled voltage.

Since the whole temporal evolution of the sampled voltage is known to the microcontroller, the microcontroller also knows the zero instants of the voltage; consequently, it knows which temporal slices of the whole acquisition of the sampled signal corresponds with certainty to non-conducting intervals of the first rectifier.

Since this slice of the sampled signal is proportional to the alternating voltage of the mains line to be measured, and since the proportionality is known according to the transformation ratio, said ratio in turn being known with precision following a simple calibration of the measuring device, it is possible to measure the value of the voltage of the electric line with great accuracy.

The measurement is carried out by interpolating only the portion of the sampled signal corresponding to the intervals when the first rectifier element is certainly not conducting, irrespective of the load, by means of a sinusoidal interpolating function.

The joint use of the second rectifier element able to obtain, at suitable time intervals, a measurement signal perfectly proportional to the mains voltage, irrespective of the absorption of the load of the supply circuit, together with the sinusoidal interpolation of the sampled signal at time intervals corresponding to the non-conducting condition of the first rectifier element, allows to achieve a much better accuracy in the measurement than what can be obtained with solutions known in the state of the art.

Furthermore, the fact that the interpolation time intervals are independent of the absorption of the load makes the solution described simple to implement and economical.

Typically, unlike measurement transformers, supply transformers have considerable magnetic hysteresis phenomena: as is known, the memory characteristic of the core of the transformer can be associated with these, and the consequent dependence of the voltage on the secondary winding in a given time instant not only on the voltage on the primary winding at the same instant, but also on the past-time evolution of the magnetic field in the core of the transformer.

In another form of embodiment of the present invention, the supply circuit comprises means configured to separate and isolate the odd half-cycles of the voltage on the secondary winding of the transformer, in order to generate the supply voltage and, in the same way, the measuring circuit comprises means configured to separate and isolate the even half-cycles of the voltage on the secondary winding of the transformer, in order to measure the voltage in the peak instants of the even half-cycles.

This solution allows a further increase in the accuracy of the measurement if the magnetic hysteresis phenomena relating to the core of the supply transformer are not negligible.

Indeed, the effects of the hysteresis are almost vanished at the time the peak value is reached when the transformer is not loaded; considering the peak instants for measuring the voltage also makes this form of embodiment simple to implement and economical, since the value of the voltage of the measuring circuit, achieved during the peak instants of the even half-cycles, is easy to detect.

The terms "even" and "odd", referring to the half-cycles of the alternating voltage, are used here and in the claims only to distinguish the alternating voltage half-cycles from each other and to identify their different use, one for supply and the other for measuring.

In one form of embodiment, the means configured to separate and isolate the odd half-cycles comprise at least a first diode and a second diode, concordant in the direction of flow of the current, connected respectively to the terminals of the supply circuit.

The means configured to separate and isolate the even half-cycles comprise at least a semiconductor device, chosen from a third diode or first current amplifier such as a transistor amplifier, which is electrically connected to the cathode of the second diode. The connection to the second diode is direct type, when a third diode is chosen, and occurs with the anode of the third diode, or by means of a resistor if a current amplifier is chosen. Furthermore, in one form of embodiment, the means to separate the even half-cycles comprise at least a fourth diode, the cathode of which is connected with the anode of the first diode and the anode of which is connected with the anode of the second diode. This latter connection, common to the supply circuit and also to the measuring circuit, can be considered as a ground reference potential node, with respect to which the voltage measurements are taken.

According to variants of the present invention, the diodes may be replaced by electronic components suitable to perform the functions of the diodes, for example transistors in diode configuration, or other semiconductor components.

Thanks to the circuit configuration described above, the peak value of the measuring half-wave voltage is positive and almost independent of the hysteresis phenomena associated with the transformer. The peak measurement of the half-wave voltage in the measuring circuit is proportional to the alternating voltage to be measured, and is carried out using one or more capacitors as memory element/s. In order to guarantee voltage values compatible with a microcontroller that presides over the measurement, it is also necessary to attenuate the measurement signal.

In one form of embodiment, to prevent a resistive attenuator from altering, by loading the secondary winding of the transformer, the peak value of the voltage to be measured, memorized by a suitable capacitor in the measuring circuit, instead of a single capacitor the circuit comprises a capacitive divider, consisting of a first capacitor series connected with a second capacitor. The divider attenuates the signal and also performs the function of storing the peak value of the measurement voltage.

In a preferential form of embodiment, the microcontroller, suitable to perform voltage measurements, is connected to the common node between the first capacitor and the second capacitor.

In a preferential form of embodiment of the present invention, the two capacitors are discharged during the voltage odd half-cycles, that is, after the peak voltage has been measured. The discharge process occurs through a discharge resistor and a first controlled switch, the closure of which is advantageously controlled by the cathode of a fifth diode which has its anode connected to the cathode of the fourth diode. According to variants of the present invention, the rectification function of the fifth diode may be considered redundant because during the even non-conducting half-cycles of the fifth diode, the fourth diode in any case conducts and therefore the potential of the cathode of the fourth diode is negative and exiguous with respect to ground, and thus does not cause any drive and/or failure of the first switch, making the use of the fifth diode unnecessary, and the closure control of the first switch is connected, either directly or by means of a resistor, to the cathode of the fourth diode.

According to a variant of the present invention, the discharge means are operated by the microcontroller, which enables the discharge of the first and second capacitor after the voltage measurement is carried out.

According to another form of embodiment, if the microcontroller provides a delayed reading of a peak voltage measurement, it is possible to keep stored the peak voltage level at the terminals of the capacitors, temporarily inhibiting the closure of the first switch, which is normally activated automatically during the odd half-cycles.

According to variants of the present invention, to obviate a possible different thermal drift of the two capacitors of the capacitive divider, a resistive divider is used, made with resistors having high Ohmic values so as not to constitute a relevant load. The resistive divider is connected to a first transistor/current amplifier configured to charge the capacitor with storing function. The first transistor, also functioning as a rectifier, may substitute the third diode. To further improve the temperature stability of the transistor, it is possible to compensate the voltage variation on its base-emitter junction using a second transistor, advantageously thermally coupled with the first, connected in a "diode" configuration and series connected to the resistor of the divider connected to ground.

According to variants of the present invention, the first transistor and the second transistor may be substituted by semiconductor electronic components which perform the same functions.

As a result, given the same transformer, the supply obtained by means of an half-wave rectifier consists of a voltage that, on average, is lower than when the full-wave rectifier is used (even if the value of the smoothing capacitor is increased) because, in order to guarantee the same average current value to the load as in the case of a full-wave rectifier (and hence the same voltage on the load), the transformer would have to deliver a higher RMS current, and therefore a bigger and more powerful transformer would be needed.

According to a variant, based on the above and in order to obviate the adoption of a more powerful transformer, when the insulated measuring device requires to use a high instantaneous power value and/or a high supply voltage, it is possible to temporarily actuate a change in the circuit topology, so that the supply circuit operates on full-wave both on voltage odd and even half-cycles. By changing the topology therefore, it is possible to modify the supply circuit, returning it to a circuit with a full-wave rectifier.

The galvanically insulated voltage measuring device according to the present invention as described heretofore obtains a precise measurement of the voltage in an electric mains line using few additional surface-mounted type components and therefore without increasing the sizes of the circuit itself, and with a very limited additional cost, even if the pre-existing supply transformer has considerable hysteresis phenomena.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a wiring diagram of a standard full-wave supply circuit that represents a voltage measuring device in the state of the art;
- fig. 2 is a graph of the voltage on the secondary winding of the transformer in fig. 1;
- fig. 3 is a graph of the voltage at the terminals of the load in fig. 1;
- fig. 4 is a wiring diagram of a device to supply and measure the voltage according to a first form of embodiment of the present invention ;
- fig. 5 is a graph of an electric quantity of the circuit in fig. 4;
- fig. 6 is a graph of an electric quantity of the circuit in fig. 4;
- fig. 7 is a graph of an electric quantity of the circuit in fig. 4;
- fig. 8 is an half-wave rectifier circuit to supply the measuring device;
- fig. 9 is a graph of the voltage on the secondary winding of the transformer in fig. 8;
- fig. 10 is a variant of the half-wave rectifier circuit in fig. 8;
- fig. 11 is an half-wave rectifier circuit to measure the voltage;
- fig. 12 is a circuit to supply and measure the voltage obtained by joining the circuits in fig. 10 and fig. 11 and conceptually representing a second form of embodiment of the present invention not burdened by the mechanisms for detecting the peak values;
- fig. 13 is a graph of the voltage on the load of the circuit in fig. 12;
- fig. 14 is a graph of the measurement voltage of the circuit in fig. 12;
- fig. 15 is a variant of the circuit to supply and measure voltage in fig. 12;
- fig. 16 is another variant of the circuit to supply and measure voltage in fig. 12;
- fig. 17 is a graph of an electric quantity of the circuits in figs. 15 and 16;
- fig. 18 is a graph of an electric quantity of the circuits in figs. 15 and 16;
- fig. 19 is another variant of the circuit to supply and measure voltage in fig. 15;
- fig. 20 is a variant of the circuit to supply and measure voltage in fig. 19;
- fig. 21 is another variant of the circuit to supply and measure voltage according to the present invention.

### DETAILED DESCRIPTION OF A PREFERENTIAL FORM OF EMBODIMENT

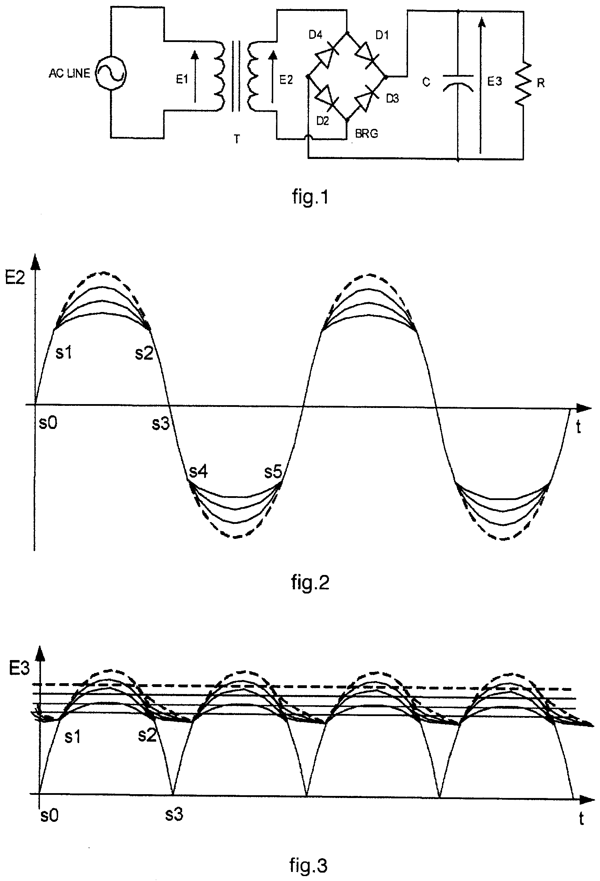

Fig. 1 shows the wiring diagram of a traditional full-wave supplier, not suitable for precise voltage measurements, which comprises a transformer T, suitable to transform the alternating voltage E1 applied to its primary winding into an alternating voltage E2 on the secondary winding. The primary winding of the transformer T is connected to the electric mains with an alternating voltage, being that mains voltage to be measured.

The device also comprises a diodes rectifier bridge BRG, suitable to convert the voltage E2 into a supply voltage E3 represented by the continuous line in the graph in fig. 3.

The output of the diode bridge BRG is connected to a capacitor C in turn parallel connected to a resistor R. The latter represents the resistive load corresponding to the overall and variable absorption of the instrument. The capacitor C, parallel connected to the load, serves to smooth, at least partly, the voltage E3 (bold lines in fig. 3).

The voltage E2 is not necessarily perfectly sinusoidal due to the load effects on the secondary winding of the transformer T due to the presence of the resistor R and the capacitor C and the fact that the transformer T itself is not ideal.

In general, and if not otherwise stated, all the drawings representing signals refer to various load situations and to the same mains voltage value. If there appears a single curve, this means that the signal is load-independent, different voltage values at the primary winding will generate different new drawings, not indicated, scaled on the voltage-axis; between the curves, those in dashes refer to the load absence condition, those in bold lines to the pertinent signal, and those in thin lines to more elementary signals from which the pertinent signals derive.

With the known supply device shown in fig. 1, the voltage waveform at the terminals of the secondary winding is described by the graph in fig. 2.

Considering the voltage E2 on the secondary winding in fig. 2, s1 and s4 are the instants, depending on the value of the variable load R, when the diode bridge BRG starts conducting (voltage on the secondary winding of the transformer greater than the voltage at the terminals of the capacitor C in fig. 1), and s2, s5 are the instants when the diode bridge BRG stops conducting. During the time intervals [s0, s1] and [s2, s4] the transformer T substantially idles. During the time intervals [s1, s2] and [s4, s5] the transformer T has a load R which represents the devices supplied.

During time intervals when the transformer T idles, the voltage E2 at the terminals of the secondary winding of the transformer T follows a scaled version (as a function of the turns ratio of the transformer T) of the sinusoidal voltage E1, but during the intervals when the diode bridge BRG is conducting, the form of the voltage E2 is distorted, that is, it is different from the form when there is no load (which is shown by the dashed line in fig. 2). The distortion of the voltage E2 with respect to the waveform of E1 mainly depends on the consumption of the load (variable over time and with environmental conditions) and on the impedance of the secondary winding of the transformer T, which is also a function of the environmental conditions, and therefore difficult to be known.

The phenomenon described entails different average values of the smoothed voltage E3 (horizontal lines in fig. 3) as the load and temperature conditions vary (the thick lines in fig. 3 represent, in different environmental and load conditions, the voltage E3 at the terminals of the capacitor C, whose average value is represented by the horizontal lines). Given that the critical instants s1, s2 and s4, s5 depend in a greatly non-linear manner on the electric circuit quantities, so do the average DC voltages (fig. 3). The voltage E3 can therefore be considered not proportional to voltage E1 and therefore the standard full-wave supply circuit is not suitable for a precise measurement of the mains voltage.

A first solution proposed in the present invention to suppress the effect of the loads and the consequent environmental dependences is to consider, for the purposes of the measurement, the secondary winding of the transformer T only in the intervals corresponding to a non-conducting state of the diode bridge BRG in the hypothesis that said non-conducting condition applies for all the situations of admissible load, that is, equivalent to absence of load.

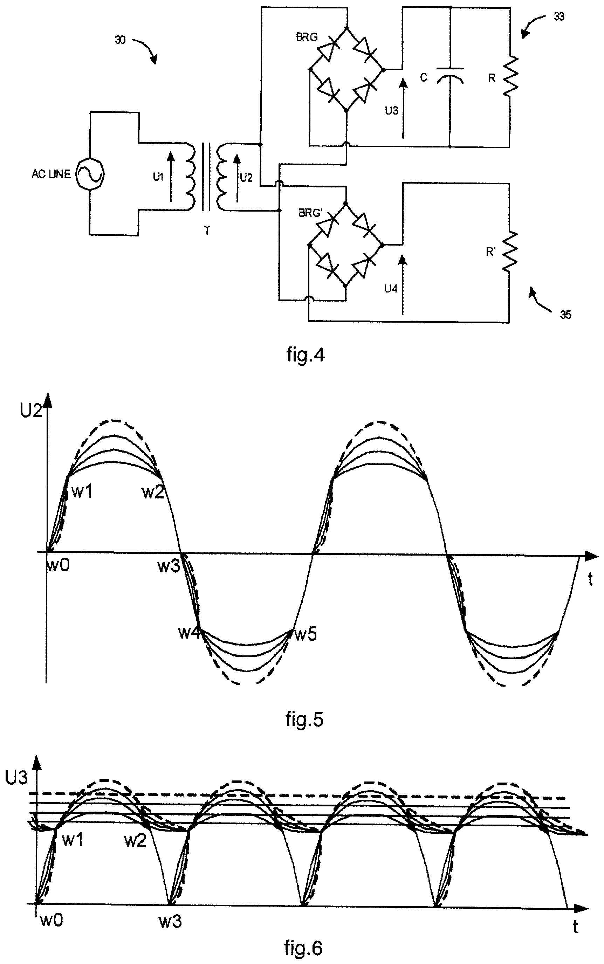

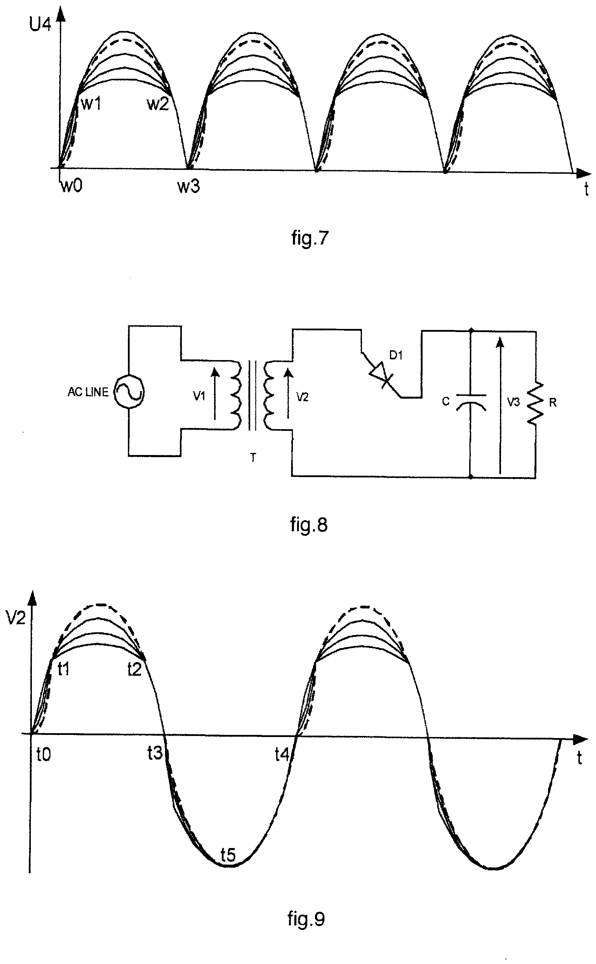

The non-conducting condition of the diode bridge BRG, valid for all admissible load conditions, is determined by intersecting the non-conducting time intervals of the diode bridge BRG associated with the various load conditions, that is, determining the widest non-conducting sub-interval common to all the load conditions. This approach, adopted in the circuit diagram shown in fig. 4, requires a duplication, with a second diode bridge BRG', of the diode bridge BRG to obtain a voltage U4 not influenced by the filtering action of the capacitor C (rectified voltages on the secondary winding, in versions influenced or not by C, are shown in fig. 6 and 7 respectively).

Since the diode bridge BRG' is not capacitively loaded, it is always in a conduction state. R' represents the equivalent resistance of the measuring circuits downstream of BRG' and must have a high resistive value, so that BRG' and its downstream circuits will cause not significant load effects on the secondary winding of the transformer T.

The estimated value of a scaled version of the rectified line voltage U1 is represented by the thick dashed line in fig. 7. The continuous lines in fig. 7 represent the value of U4 which is affected by error during the conduction intervals of the bridge BRG, and is not coincident with a scaled version of U1 in all load conditions.

The circuit diagram in fig. 4 represents a first diagram of a measuring device 30, which comprises two different circuits with different functions: a supply circuit 33 and a measuring circuit 35, supplied by the supply circuit 33.

A microcontroller (not shown), which is part of the measuring circuit 35, will extrapolate the estimation of the mains voltage processing an attenuated version of the signal U4 only in the time intervals when this faithfully follows the scaled version of the rectified mains voltage, that is, during the non-conducting intervals of the main bridge BRG common to all load conditions, intervals predetermined a-priori by the intersection operation as described above according to the circuit elements and the set of admissible values. The signal processing required from the microcontroller can be heavy, and this may constitute a first disadvantage of this approach.

A big contribution to the growth of the measuring error derives from the hysteresis phenomena of the ferromagnetic core of the transformer T which shows a "memory" characteristic, that introduces a distortion on the voltage on the secondary winding also in the non-conducting intervals [w0, w1] etc. (spreads of the curves in intervals [w0, w1] and [w3, w4] in fig. 5). The memory effect of the ferromagnetic core of the transformer T, due to the currents on the windings in the previous conduction periods, is a phenomenon dependent on the load/ environment that induces an error in the estimation of the voltage and therefore this approach may not be sufficiently precise in the event that the hysteresis phenomena associated with the transformer are not negligible.

In an half-wave rectifier (fig. 8) the diode D1 (and therefore also the secondary winding of the transformer T) conducts for a portion of just one of the two half-periods and during the other half-period does not conduct. A quarter-period non-conducting state reduces the memory effect of the core of the transformer T, resulting in a peak value of the measuring even half-wave (the one when the diode D 1 is in completely non-conduction, during which the load effect on the transformer is negligible) almost independent of the supplied load: considering only the half-wave rectifier element in fig. 8, which has the supply function, it may be noted that the negative voltage peak value V2 on the secondary winding (reached at instant t5 in fig. 9) is stable and independent of the load, of the environmental conditions and of the hysteresis phenomena on the transformer (V2 is shown with a thick line and the scaled version of V1 with a dashed line, the spreads of the curves in the interval [t3, t5] represents the effects related to the hysteresis phenomena in the core of the transformer eventually residual during the initial part of the even half-wave of complete non-conduction for the diode D1).

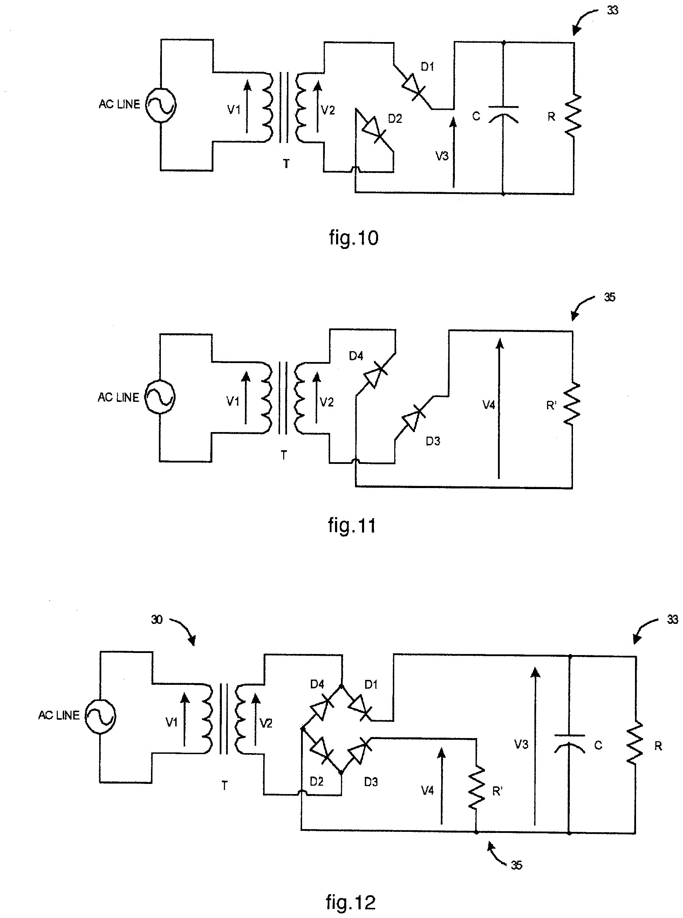

In the variant shown in fig. 10, a second diode D2 is introduced, without variations to the functional behavior of the rectifier (since D1 and D2 are series connected).

In the same way, in fig. 11 we have a second rectifier circuit able to work with the other voltage half-wave. This additional rectifier does not, at the moment, have a capacitive type load (hereafter a purely capacitive load will be introduced in order to detect the peak value), and the value of R' can be assumed to be very high, so that it can be assumed that the transformer substantially idles during the conduction half-cycles of the diodes D3 and D4. Consequently, the second half-wave rectifier (fig. 11) can be connected to the secondary winding in fig. 10 substantially without altering the load conditions, and hence without introducing further distortions.

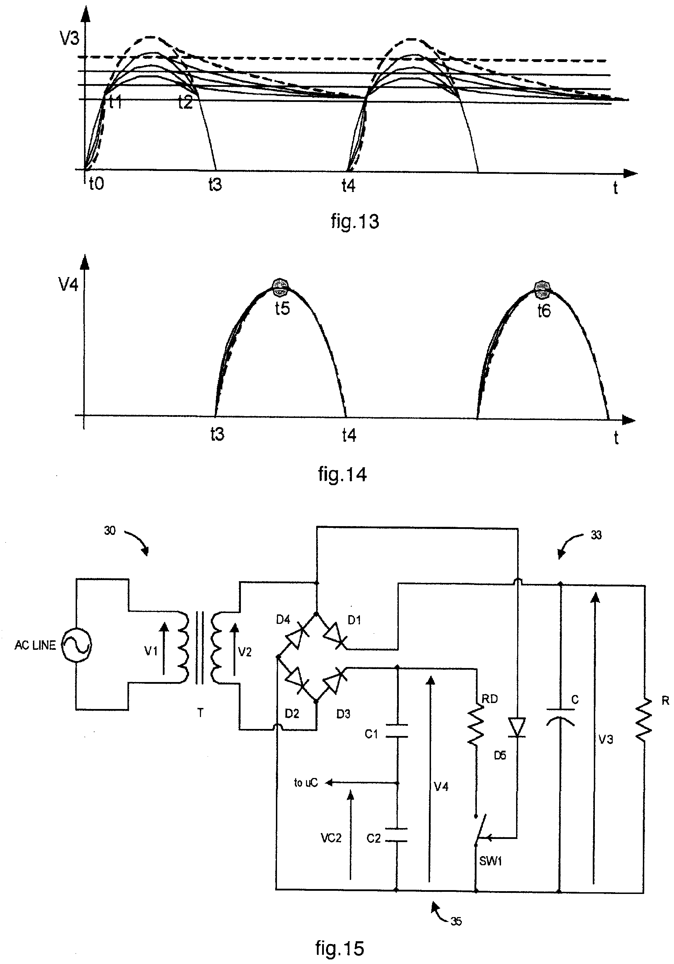

By joining the two half-wave rectifiers a two outputs rectifier is obtained, which can carry out the function of a measuring device 30 (fig. 12). The first output, having a voltage V3 represented with a thick line in fig. 13, represents the supply voltage at output of the supply circuit 33. The second output, having a voltage V4, shown in fig. 14, represents the electrical quantity of the measuring circuit 35 on which to take the peak measurements. The measuring circuit 35 is supplied by the supply circuit 33. The configuration of the circuit in fig. 12 is very similar to the one shown in fig. 1 and is obtained from the latter by opening the connection (in the bridge BRG) between the diodes D1 and D3 and separating the outputs. Now, the measurement signal (fig. 14) has stable positive peak values independent of the load, of the environmental conditions and of the hysteresis phenomena associated with the core of the transformer T.

The invention also allows to identify the peaks of the voltage V4 (shown with little balls in fig. 14) very simply. In principle, this function can be performed by means of the microcontroller, but to this purpose it requires a quick sampling of the signal V4, that is, it requires large resources amount of the microcontroller. If the resistor R' is replaced by a purely capacitive load, the peak level is maintained and can easily be read by the microcontroller asynchronously (that is, with some delay from the instant when the peak is reached). As shown in fig. 15, two capacitors C1 and C2 can be introduced, series connected to each other, to obtain the effect of attenuating the voltage V4 providing a voltage VC2 compatible with the analog input of the microcontroller, and without introducing a resistive load effect, that is, without altering the ability to store the peak value correctly. The analog sampling input of the microcontroller is connected to the node common to capacitors C1 and C2, and is subject to voltage VC2 (figs. 15, 19 and 20).

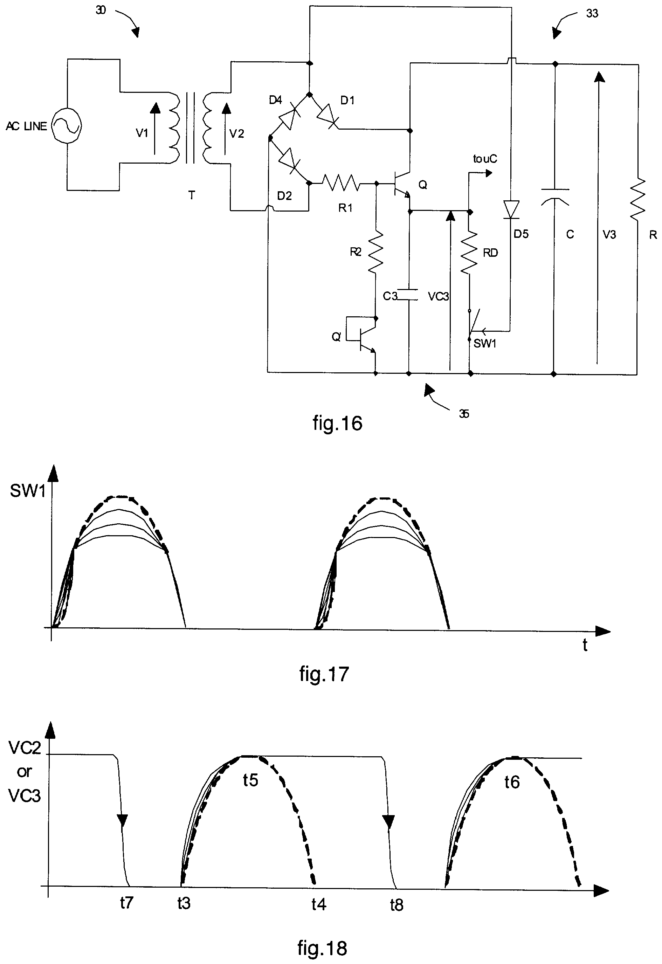

The peak value of VC2, proportional to that of V4, is shown by the continuous line in fig. 18 and can be read indifferently at any moment between instants t5 and t8. To improve the detection, it is however necessary to discharge the capacitors C1 and C2 before the following measures on the even half-waves, to prevent the previous peak value from being maintained as the stored peak when a lower voltage peak than the previous one is reached in the subsequent even half-cycles.

This discharge of the capacitors C1 and C2 can be carried out automatically during the odd half-cycle following the even measurement half-cycle which we are referring to. A switch SW1 is then introduced (fig. 15), controlled by the peak of the odd voltage half-cycles, taken at the node between the diodes D4 and D1. As it closes, the switch SW1, controlled by means of the diode D5, enables the discharge of the capacitors C1 and C2, in the appropriate time instants (t7 and t8 in fig. 18), through a discharge resistor RD. The use of the diode D5 is optional, since during the even non-conducting half-cycles of D5, the potential on the cathode of the fourth diode D4 (conducting in said half-cycles) is negative and exiguous with respect to ground and therefore does not cause any drive and/or failure of the switch SW1 when the latter is driven deriving a signal (direct connection or by means of a resistor) from the cathode of the fourth diode D4.

It is better if the discharge of the capacitors C1 and C2 is automatically controlled electronically by the switch SW1 (and optionally by the diode D5) and not left solely to the control of the microcontroller: an incorrect timing of the closure of SW1 could damage the discharge resistor RD (that is a low value resistor) or the switch itself (for example if, for any reason whatsoever, it closed during the even measurement half-cycles when the diode D3 is still conducting).

If the two capacitors have a different temperature coefficients, their ratio (and hence the attenuation factor) is subject to thermal drift that affects the measurement. To obviate this problem a variant of the present invention is introduced, having a resistive divider (R1 and R2 in fig. 16) whose Ohmic values must also be high, so as not to introduce load effect and distortions. Made with high Ohmic values, the resistive divider is not however able to fast charge the capacitor C3, which is provided to store the peak value of the measurement voltage VC3, and therefore it becomes necessary to introduce the transistor Q, functioning as a current amplifier (in emitter follower configuration) and, to partly compensate the variation in temperature of its VBE, a second transistor Q', thermally coupled with Q, connected so as to obtain a diode (connecting base and collector together) and series connected to the resistor R2 as shown in fig. 16. Since the transistor Q also functions as a rectifier, it can in practice replace the diode D3 in the previous diagrams.

If the mains voltage does not need to be measured on every cycle, it is possible to provide a temporal extension of the maintenance of stored the peak voltage value at the terminals of the capacitors C1 and C2 (or C3 in the case of fig. 16), so as to simplify the reading of the signal by the microcontroller: this can be done without further components and retaining the automatism regarding the closure of SW1, providing the switch SW1 with an inhibit control signal driven by the microcontroller.

Following the circuit modifications made to the full-wave rectifier power supply not suitable for a precise measurement of the mains voltage (fig. 1), with reference to the generation of the DC supply voltage, the original full-wave rectifier was modified to an half-wave rectifier which has a wider ripple in output voltage compared to the original full-wave rectifier (fig. 13). To maintain the ripple voltage at the original value, the capacitor C should be doubled in value, introducing a further cost and an increase in sizes of the measuring device 30.

In the same way, using an half-wave rectifier instead of a full-wave rectifier to supply the measuring device would require a transformer more powerful by about 40% (this is the increase in the RMS current needed to maintain the same average current value on the load). If these two re-sizings are ignored, there is a consequent reduction in the supply voltage.

An important fact related to the real usage of the described device, is that a high supply voltage value is required from the supply circuit 33 only at determinate instants (for example to actuate a relay it is necessary to apply an excitation voltage) but not during normal operations (to keep a relay in an active condition a considerably lower voltage than the excitation voltage, called maintenance voltage, is sufficient): this is particularly true in applications for which the present invention was studied, and in general in systems where the relays are used to switch loads.

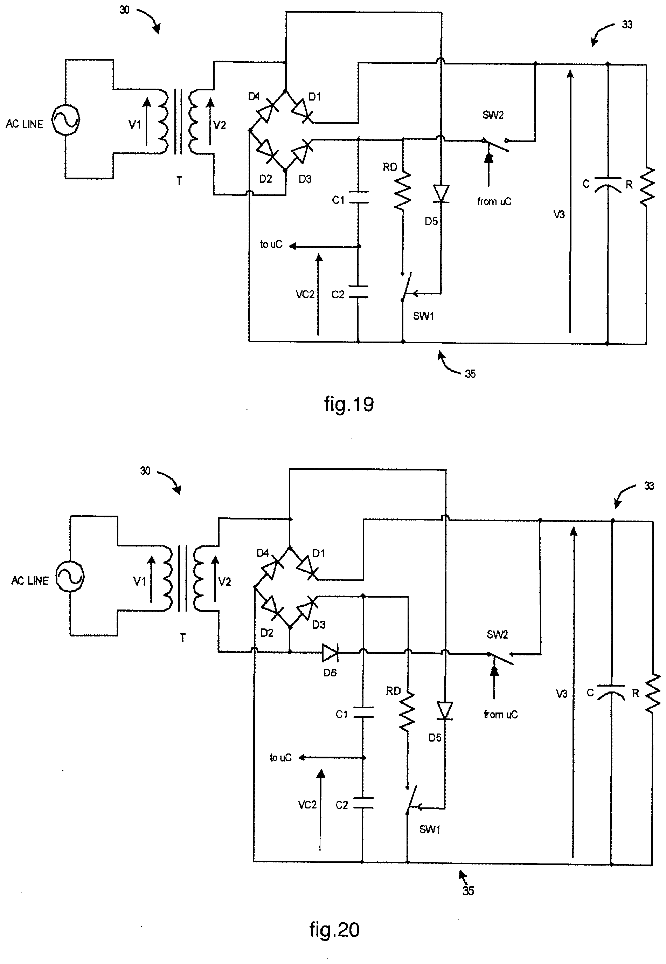

To overcome the need to re-size the transformer T and the capacitor C, originally sized with reference to the full-wave rectifier intended for the supply function, thus increasing costs and bulk, in accordance with the considerations made above, it is sufficient to introduce an auxiliary switch (SW2 in figs. 19, 20 and 21) driven by the microcontroller: immediately before the application requires a high level voltage V3 (for example before switching on a relay), the microcontroller, closing the auxiliary switch SW2, restores the original voltage level V3 (the one obtainable by means of the full-wave rectifier shown in fig. 1); as soon as the need for a high level voltage V3 ceases, the microcontroller opens the auxiliary switch SW2 restoring the measuring layout.

During the intervals when the auxiliary switch SW2 is closed, the measurement signal is corrupted being affected by the load effects of the supply circuit 33; this is irrelevant, however, because the closures of the auxiliary switch SW2 are sporadic (once every many half-waves) and only last few milliseconds; moreover, a precise measurement is obtainable since the next even half-wave following the opening of the auxiliary switch SW2.

The closure of the auxiliary switch SW2 (fig. 19) re-closes the diode bridge D1, D2, D3 and D4, in practice restoring the full-wave rectifier configuration of fig. 1.

The form of embodiment in fig. 20 provides to duplicate the diode D3 (introduction of a diode D6) to correct a collateral effect of the closure of the auxiliary switch SW2: in fig. 19, assuming that switch SW2 is closed, during the odd half-cycles, when SW1 also closes in order to discharge capacitors C1 and C2, a high value current may flow through the branch formed by D1, SW2, RD and SW1. The adoption of the diode D6 in the circuit diagram in fig. 20 prevents any current from flowing through this path (SW2 not directly connected to RD but by means of two diodes anti-series connected) and at the same time diode D6 provides the path for the current to flow (through SW2) from the transformer to the load during the even half-waves in the full-wave configuration.

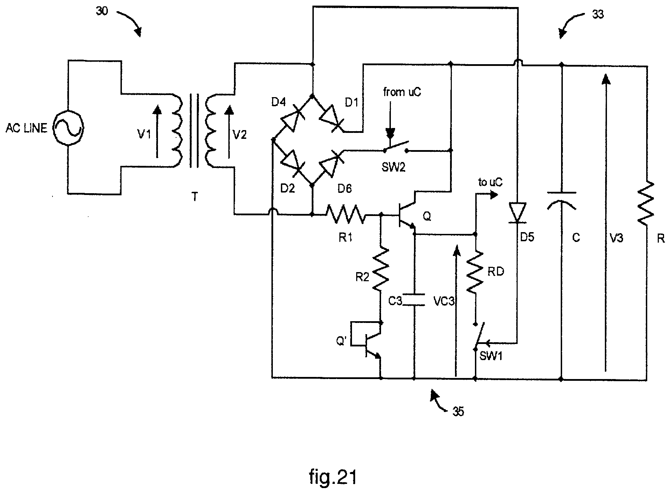

For the same reason the diode D6 is present in the final diagram in fig. 21, where is adopted the solution with the resistive divider (R1, R2) with transistor type current amplifier and compensation of the VBE. In this diagram the transistor Q replaces the diode D3 present in the previous ones.

It is clear that modifications and/or additions of parts may be made to the device for measuring voltage as described heretofore, without departing from the field and scope of the present invention.

## Claims

1. Measuring device, of the galvanic insulation type, to measure an alternating voltage (U1) of an electric mains line, comprising a measuring circuit (35), having a microcontroller, a supply circuit (33) able to supply at least said measuring circuit (35), and a transformer (T), having a primary winding powered by the mains sinusoidal voltage (U1), connected to said electric line, and a secondary winding with a voltage (U2), connected both to said measuring circuit (35) and also to said supply circuit (33), said measuring device being **characterized in that** said supply circuit (33) and said measuring circuit (35) comprise respectively a first and a second full-wave rectifier elements (BRG, BRG'), distinct from each other, wherein the second rectifier element (BRG') is configured so as not to generate load effects on the secondary winding of the transformer (T), said rectifier element (BRG') being loaded with a high value impedance (R'), said first and second rectifier element (BRG, BRG') being able to convert the alternating voltage (U2) of the secondary winding of the transformer (T) into respective first and second full-wave rectified voltages (U3, U4), and also **characterized in that** said measuring circuit (35) is configured to consider the second full-wave rectified voltage (U4) in time intervals ([w0, w1], [w2, w4]) independent of the load of the supply circuit (33) during which the load effect of the supply circuit (33) on the secondary winding of the transformer (T) is negligible, that is, within time intervals during which the first rectifier element (BRG) does not conduct, in said time intervals ([w0, w1], [w2, t4]) said second full-wave rectified voltage (U4) being substantially proportional to said alternating voltage (U1) to be measured, said time intervals ([w0, w1], [w2, t4]) being parameterized in the non-volatile memory of the microcontroller by means of predetermined constants as a function of the value of the circuit components and said intervals being non-conductive for the first rectifier element (BRG) whatever the instantaneous value of the load (R) admissible for the supply circuit (33).

2. Measuring device, of the galvanic insulation type, to measure an alternating voltage (V1) of an electric mains line, comprising a measuring circuit (35), having a microcontroller, a supply circuit (33), able to supply at least said measuring circuit (35), and a transformer (T), having a primary winding powered by the mains sinusoidal voltage (V1), connected to said electric line, and a secondary winding with a voltage (V2) connected both to said measuring circuit (35) and also to said supply circuit (33), the measuring device being **characterized in that** said supply circuit (33) comprises first means (D1, D2) configured to separate and insulate the odd half-cycles of the voltage (V2) present in said secondary winding of said transformer (T) and **characterized in that** said measuring circuit (35) comprises second means (D3, D4, Q) configured to separate and insulate the even half-cycles of the voltage (V2) present in said secondary winding of said transformer (T) in order to carry out the voltage measurements, wherein said odd voltage half-cycles (V3) are used to supply said measuring circuit (35) and said even voltage half-cycles (V4) are used to measure the voltage on the electric mains, said measuring circuit (35) being configured to consider said even voltage half-cycles (V4) in the relative peak time instants (t5, t6) in which the peak voltages are substantially independent of the voltage odd half-cycles (V3) of said supply circuit (33), the magnetic hysteresis phenomena of the core of the transformer (T), due to the previous odd half-cycles of the supply voltage (V3), being almost extinct in said peak time instants (t5, t6), being minimal, in said peak time instants (t5, t6) of the even half-cycles of the measuring voltage (V4), the residual memory of the previous odd half-cycles of the supply voltage (V3), so that the peak values of said voltage even half-cycles (V4) are proportional to the peak values of said alternating voltage (V1) to be measured.

3. Device as in claim 2, **characterized in that** said first means (D1, D2) comprise a first diode (D1) and a second diode (D2), said diodes (D1, D2) being concordant in the direction of the current flow and connected respectively to the terminals of said secondary winding of the transformer (T), and **in that** said second means (D3, D4, Q) comprise a first semiconductor device (D3 and/or Q), directly or indirectly connected to the cathode of said second diode (D2), and a fourth diode (D4), whose cathode is connected to the anode of said first diode (D1) and whose anode is connected to the anode of said second diode (D2).

4. Device as in claim 3, **characterized in that** said measuring circuit (35) comprises a capacitive divider, having the double function of storing the peak value of the measuring voltage (V4) detected in the even half-cycles and dividing the value of said peak voltage, having a first capacitor (C1) and a second capacitor (C2), series connected with said first capacitor (C1), and wherein the microcontroller, able to carry out voltage measurements, has its measurement input connected at least to the common node between the first capacitor (C1) and the second capacitor (C2) .

5. Device as in claim 4, **characterized in that** it comprises discharge means (RD, SW1) able to automatically discharge said first capacitor (C1) and said second capacitor (C2) during at least one odd voltage half-cycle.

6. Device as in claim 4, **characterized in that** it comprises discharge means (RD, SW1) able to discharge said first capacitor (C1) and said second capacitor (C2) on control of said microcontroller following a measurement made by said microcontroller.

7. Device as in claim 5, **characterized in that** said discharge means (RD, SW1) comprise a discharge resistor (RD) and a first switch (SW1), each other series connected, said series being connected in parallel to the series of said first capacitor (C1) and said second capacitor (C2) and **in that** the closure of the first switch (SW1) is controlled by a signal deriving from the cathode of said fourth diode (D4).

8. Device as in claims 5 and 7, **characterized in that** said microcontroller is able to inhibit the action of said first discharge switch (SW1) so as to keep stored the peak value of the voltage (V4) detected in the course of an even half-cycle at the terminals of said first capacitor (C1) and of said second capacitor (C2), the discharge of said capacitors being inhibited.

9. Device as in claim 3, **characterized in that** said first semiconductor device comprises a current amplifier such as a transistor (Q) **and in that** the measuring circuit (35) comprises a resistive divider (R1, R2) connected to said current amplifier able to charge a third memory capacitor (C3), wherein the microcontroller is connected to said memory capacitor (C3), **and characterized in that** said memory capacitor (C3) is able to store the scaled version by said resistive divider (R1, R2) of the peak value of the measurement voltage (V4) detected in the even half-cycles.

10. Device as in claim 9, **characterized in that** it comprises a second transistor (Q') series connected to one of the two resistors (R1, R2), able to compensate the drift of the base-emitter junction voltage of said amplifier transistor (Q).

11. Device as in claim 10, **characterized in that** said second transistor (Q') is thermally coupled with said amplifier transistor (Q).

12. Device as in claims 9, 10 and 11, **characterized in that** it comprises discharge means (RD, SW1) able to automatically discharge said third memory capacitor (C3) during at least one odd voltage half-cycle.

13. Device as in claims 9, 10 and 11, **characterized in that** it comprises discharge means (RD, SW1) able to discharge said memory capacitor (C3) and directly controlled by said microcontroller following a measurement made by said microcontroller.

14. Device as in claim 12, **characterized in that** said discharge means (RD, SW1) comprise a discharge resistor (RD) and a first switch (SW1), each other series connected, said series being connected in parallel to said memory capacitor (C3), and **in that** the closure of said first switch (SW1) is controlled by a signal deriving from the cathode of said fourth diode (D4).

15. Device as in claims 12 and 14, **characterized in that** said microcontroller is able to inhibit the action of said first discharge switch (SW1) so as to keep memory of the scaled version by said resistive divider (R1, R2) of the peak value of the measurement voltage (V4) detected in the even half-cycles, said scaled version of the peak value being represented by the voltage (VC3) at the terminals of the above-cited memory capacitor (C3), the discharge of said memory capacitor (C3) being inhibited because of the inhibition of the action of said discharge switch (SW1).

16. Device as in any claim from 2 to 15, **characterized in that** it comprises change means (SW2, D6), controlled by the microcontroller, acting on the circuit topology of said supply circuit (33) in order to make it operate in full-wave rectification mode.

17. Method to measure an alternating voltage (U1) of an electric mains line by means of a measuring device of the galvanic insulation type, having a measuring circuit (35), provided with a microcontroller, associated with a supply circuit (33) and a transformer (T), provided with a primary winding, powered by the mains sinusoidal voltage (U1) and connected to said electric line, and a secondary winding subjected to a voltage (U2), connected both to said measuring circuit (35) and also to said supply circuit (33), **characterized in that** said method comprises:
- a first step during which a first full-wave rectifier element (BRG) of said supply circuit (33) converts the alternating voltage (U2) of said secondary winding into a first full-wave rectified voltage (U3),
- a second step, simultaneous to the first step, in which a second full-wave rectifier element (BRG') of said measuring circuit (35) converts the alternating voltage (U2) of said secondary winding into a second full-wave rectified voltage (U4), wherein said second rectifier element (BRG') does not generate load effects on the secondary winding of the transformer (T), said rectifier element (BRG') being loaded by a high value impedance (R'), and
- a third step, simultaneous with part of the first and second step, in which said first rectifier element (BRG) of said supply circuit (33) does not conduct current and said microcontroller evaluates the attenuated and sampled version of said waveform of the second full-wave rectified voltage (U4) downstream of said second rectifier element (BRG') of said measuring circuit (35) at time intervals ([w0, w1], [w2, t4]) independent of the load of the supply circuit (33) and placed across matched time instants (w0, w3) where the second full-wave rectified voltage (U4) vanishes, that is, in time intervals in which said second full-wave rectified voltage (U4) downstream of said second rectifier element (BRG'), irrespective of the load of the supply circuit (33), is proportional to said sinusoidal voltage (U1) to be measured, said time intervals ([w0, w1], [w2, t4]) being parameterized in the non-volatile memory of the microcontroller by means of constants predetermined as a function of the value of the circuit components and said intervals being non-conductive intervals for the rectifier (BRG) whatever the instantaneous value of the load (R) admissible for the supply circuit (33).

18. Method to measure an alternating voltage of an electric mains line by means of a measuring device of the galvanic insulation type, having a measuring circuit (35), a supply circuit (33) and a transformer (T), provided with a primary winding, powered by the mains sinusoidal voltage (V1), connected to said electric line, and with a secondary winding subjected to a voltage (V2), connected to said measuring circuit (35) and to said supply circuit (33), **characterized in that** said method provides:
- a first step in which said supply circuit (33) is half-wave type and uses the voltage odd half-cycles (V3) to supply at least said measuring circuit (35), and
- a second step, temporally alternate to the first step, in which said measuring circuit (35) is half-wave rectifier-type and carries out the measurements on the voltage even half-cycles (V4), in the relative peak time instants (t5, t6) in which said measurements are substantially independent of the voltage odd half-cycles (V3) of said supply circuit (33), the magnetic hysteresis phenomena in the core of the transformer (T), attributable to the previous odd half-cycles of the supply voltage (V3), being almost extinct in said peak time instants (t5, t6), being, in said peak time instants (t5, t6) of the even half-cycles of the measurement voltage (V4), a minimum residual memory of the previous odd half-cycles of the supply voltage (V3), so that the peak values of said voltage even half-cycles (V4) are proportional to the peak values of said alternating voltage (V1) to be measured.

19. Method as in claim 18, **characterized in that** said second step provides second means, for example a third diode (D3) and/or a current amplifier such as a transistor (Q), and a fourth diode (D4), which are part of the measuring circuit (35), that receive at input the voltage of the secondary winding (V2) of said transformer (T) and allow to pass only the voltage even half-waves (V4).

20. Method as in claim 18 or 19, **characterized in that** it comprises a fourth step in which change means (SW2, D6), controlled at the discretion of the microcontroller, act on the circuit topology so that the supply circuit (33) operates as full-wave rectifier.

## Patentansprüche

1. Messvorrichtung galvanisch isolierter Art zum Messen einer Wechselspannung (U1) einer elektrischen Netzleitung, aufweisend
eine Messschaltung (35) mit einem Mikrocontroller,
eine Versorgungsschaltung (33), die eingerichtet ist, mindestens die Messschaltung (35) zu versorgen, und
einen Transformator (T) mit einer Primärwicklung, die von der Netzsinusspannung (U1) gespeist wird und die mit der elektrischen Leitung verbunden ist, und einer Sekundärwicklung mit einer Spannung (U2), die sowohl mit der Messschaltung (35) als auch mit der Versorgungsschaltung (33) verbunden ist,
wobei die Messvorrichtung
**dadurch gekennzeichnet ist, dass**
die Versorgungsschaltung (33) und die Messschaltung (35) jeweils ein erstes und ein zweites Vollwellen-Gleichrichterelement (BRG, BRG'), die zueinander unterschiedlich sind, aufweisen,
wobei das zweite Gleichrichterelement (BRG') so eingerichtet ist, dass es keine Lasteffekte auf die Sekundärwicklung des Transformators (T) erzeugt, wobei das Gleichrichterelement (BRG') mit einer hochohmigen Impedanz (R') belastet ist,
wobei das erste und zweite Gleichrichterelement (BRG, BRG') eingerichtet sind, die Wechselspannung (U2) der Sekundärwicklung des Transformators (T) in jeweilige erste und zweite gleichgerichtete Vollwellen-Spannungen (U3, U4) umzuwandeln, und ferner
**dadurch gekennzeichnet ist, dass**
die Messschaltung (35) so eingerichtet ist, die zweite gleichgerichtete Vollwellen-Spannung (U4) in Zeitintervallen ([w0, w1], [w2, w4]) unabhängig von der Last der Versorgungsschaltung (33), während derer der Lasteffekt der Versorgungsschaltung (33) auf die die Sekundärwicklung des Transformators (T) vernachlässigbar ist, zu berücksichtigen, das heißt innerhalb von Zeitintervallen, während denen das erste Gleichrichterelement (BRG) nicht leitet; in den Zeitintervallen ([w0, w1], [w2, t4]), in denen die zweite gleichgerichtete Vollwellen-Spannung (U4) im Wesentlichen proportional zu der zu messenden Wechselspannung (U1) ist; in den Zeitintervallen ([w0, w1], [w2, t4]), die in dem nichtflüchtigen Speicher des Mikrocontrollers parametrisiert sind mittels vorbestimmter Konstanten als eine Funktion des Wertes der Schaltungskomponenten; und den Intervallen, die für das erste Gleichrichterelement (BRG) unabhängig vom derzeitigen Wert der Last (R), die für die Versorgungsschaltung (33) zulässig ist, nicht leitend sind.

2. Messvorrichtung galvanisch isolierter Art zum Messen einer Wechselspannung (V1) einer elektrischen Netzleitung, aufweisend eine Messschaltung (35) mit einem Mikrocontroller,
eine Versorgungsschaltung (33), die eingerichtet ist, zumindest die Messschaltung (35) zu versorgen, und
einen Transformator (T) mit einer Primärwicklung, die von der Netzsinusspannung (V1) gespeist wird und mit der elektrischen Leitung verbunden ist, und einer Sekundärwicklung mit einer Spannung (V2), die sowohl mit der Messschaltung (35) als auch mit der Versorgungsschaltung (33) verbunden ist,
wobei die Messvorrichtung
**dadurch gekennzeichnet ist, dass**
die Versorgungsschaltung (33) erste Mittel (D1, D2) aufweist, die eingerichtet sind, die ungeraden Halbperioden der Spannung (V2), die in der Sekundärwicklung des Transformators (T) vorhanden sind, zu trennen und zu isolieren und
**dadurch gekennzeichnet ist, dass**
die Messschaltung (35) zweite Mittel (D3, D4, Q) aufweist, die eingerichtet sind, die geraden Halbperioden der Spannung (V2), die in der Sekundärwicklung des Transformators (T) vorhanden ist, zu trennen und zu isolieren, um die Spannungsmessungen durchzuführen,
wobei die ungeraden Spannungs-Halbperioden (V3) verwendet werden, die Messschaltung (35) zu versorgen, und die geraden Spannungs-Halbperioden (V4) verwendet werden, die Spannung am elektrischen Netz zu messen, wobei die Messschaltung (35) eingerichtet ist, die geraden Spannungs-Halbperioden (V4) in den relativen Spitzenzeitpunkten (t5, t6) zu berücksichtigen, in denen
die Spitzenspannungen im Wesentlichen unabhängig von den ungeraden Spannungs-Halbperioden (V3) der Versorgungsschaltung (33) sind, das magnetische Hysterese-Phänomen des Kerns des Transformators (T) aufgrund der vorhergehenden ungeraden Halbperioden der Versorgungsspannung (V3) in den Spitzenzeitpunkten (t5, t6) nahezu nicht mehr existiert,
in den Spitzenzeitpunkten (t5, t6) der geraden Halbperioden der Messspannung (V4), der Restspeicher der vorangegangenen ungeraden Halbperioden der Versorgungsspannung (V3) minimal ist, so dass die Spitzenwerte dieser geraden Spannungs-Halbperioden (V4) proportional zu den Spitzenwerten der zu messenden Wechselspannung (V1) sind.

3. Vorrichtung nach Anspruch 2, **dadurch gekennzeichnet, dass** die ersten Mittel (D1, D2) eine erste Diode (D1) und eine zweite Diode (D2) aufweisen,
wobei die Dioden (D1, D2) in der Richtung des Stromflusses übereinstimmen und jeweils mit den Anschlüssen der Sekundärwicklung des Transformators (T) verbunden sind, und
**dadurch gekennzeichnet, dass**
die zweiten Mittel (D3, D4, Q) ein erstes Halbleiterbauelement (D3 und/oder Q) aufweisen, das direkt oder indirekt mit der Kathode der zweiten Diode (D2) verbunden ist, und eine vierte Diode (D4), deren Kathode mit der Anode der ersten Diode (D1) verbunden ist und deren Anode mit der Anode der zweiten Diode (D2) verbunden ist.

4. Vorrichtung nach Anspruch 3, **dadurch gekennzeichnet, dass** die Messschaltung (35) einen kapazitiven Teiler aufweist, der die doppelte Funktion hat, den Spitzenwert der Messspannung (V4), der in den geraden Halbperioden erfasst wird, zu speichern und den Wert der Spitzenspannung zu teilen; mit einem ersten Kondensator (C1) und einem zweiten Kondensator (C2), der in Reihe mit dem ersten Kondensator (C1) verbunden ist, und wobei der Mikrocontroller, der eingerichtet ist, Spannungsmessungen durchzuführen, seinen Messeingang mindestens mit dem gemeinsamen Knoten zwischen dem ersten Kondensator (C1) und dem zweiten Kondensator (C2) verbunden hat.

5. Vorrichtung nach Anspruch 4, **dadurch gekennzeichnet, dass** sie eine Entladungseinrichtung (RD, SW1) aufweist, die eingerichtet ist, den ersten Kondensator (C1) und den zweiten Kondensator (C2) während mindestens einer ungeraden Spannungs-Halbperiode automatisch zu entladen.

6. Vorrichtung nach Anspruch 4, **dadurch gekennzeichnet, dass** sie eine Entladungseinrichtung (RD, SW1) aufweist, die eingerichtet ist, den ersten Kondensator (C1) und den zweiten Kondensator (C2) durch Steuerung des Mikrocontrollers nach einer Messung, die durch den Mikrocontroller durchgeführt wurde, zu entladen.

7. Vorrichtung nach Anspruch 5, **dadurch gekennzeichnet, dass** die Entladungseinrichtung (RD, SW1) einen Entladungswiderstand (RD) und einen ersten Schalter (SW1) aufweist, die jeweils in Reihe geschaltet sind, wobei die Reihe parallel zu der Reihe des ersten Kondensators (C1) und des zweiten Kondensators (C2) ist und
**dadurch gekennzeichnet, dass**
das Schließen des ersten Schalters (SW1) durch ein Signal gesteuert wird, das von der Kathode der vierten Diode (D4) abgeleitet ist.

8. Vorrichtung nach den Ansprüchen 5 und 7, **dadurch gekennzeichnet, dass** der Mikrocontroller eingerichtet ist, die Funktion des ersten Entlade-Schalters (SW1) zu verhindern, um den Spitzenwert der Spannung (V4), der im Verlauf einer geraden Halbperiode an den Anschlüssen des ersten Kondensators (C1) und des zweiten Kondensators (C2) erfasst wurde, gespeichert zu halten, wobei die Entladung der Kondensatoren verhindert wird.

9. Vorrichtung nach Anspruch 3, **dadurch gekennzeichnet, dass** die erste Halbleitervorrichtung einen Stromverstärker wie einen Transistor (Q) aufweist, und
**dadurch gekennzeichnet, dass**
die Messschaltung (35) einen Widerstandsteiler (R1, R2) aufweist, der mit dem Stromverstärker verbunden ist, der eingerichtet ist, einen dritten Speicherkondensator (C3) zu laden, wobei der Mikrocontroller mit dem Speicherkondensator (C3) verbunden ist, und
**dadurch gekennzeichnet, dass**
der Speicherkondensator (C3) eingerichtet ist, die durch den Widerstandsteiler (R1, R2) skalierte Version des Spitzenwertes der Messspannung (V4), der in den geraden Halbperioden erfasst wird, zu speichern.

10. Vorrichtung nach Anspruch 9, **dadurch gekennzeichnet, dass** sie einen zweiten Transistor (Q') aufweist, der mit einem der beiden Widerstände (R1, R2) in Reihe verbunden ist, eingerichtet, um den Drift der Basis-Emitter-Verbindungsspannung des Verstärkertransistors (Q) zu kompensieren.

11. Vorrichtung nach Anspruch 10, **dadurch gekennzeichnet, dass** der zweite Transistor (Q') thermisch mit dem Verstärkertransistor (Q) gekoppelt ist.

12. Vorrichtung nach Anspruch 9, 10 und 11, **dadurch gekennzeichnet, dass** sie eine Entladungseinrichtung (RD, SW1) aufweist, die eingerichtet ist, den dritten Speicherkondensator (C3) während wenigstens einer ungeraden Halbperiode der Spannung automatisch zu entladen.

13. Vorrichtung nach den Ansprüchen 9, 10 und 11,
**dadurch gekennzeichnet, dass**
sie eine Entladungseinrichtung (RD, SW1) aufweist, die eingerichtet ist, den Speicherkondensator (C3) zu entladen und direkt von dem Mikrocontroller nach einer von dem Mikrocontroller durchgeführten Messung gesteuert wird.

14. Vorrichtung nach Anspruch 12, **dadurch gekennzeichnet, dass** die Entladungseinrichtung (RD, SW1) einen Entladungswiderstand (RD) und einen ersten Schalter (SW1) aufweist, die jeweils in Reihe geschaltet sind, wobei die Reihe parallel zu dem Speicherkondensator (C3) geschaltet ist, und **dadurch gekennzeichnet, dass**
das Schließen des ersten Schalters (SW1) durch ein Signal gesteuert wird, das von der Kathode der vierten Diode (D4) abgeleitet ist.

15. Vorrichtung nach Anspruch 12 und 14, **dadurch gekennzeichnet, dass** der Mikrocontroller eingerichtet ist, die Funktion des ersten Entlade-Schalters (SW1) zu verhindern, um die durch den Widerstandsteiler (R1, R2) skalierte Version des Spitzenwerts der Messspannung (V4), die in den geraden Halbperioden erfasst wird, gespeichert zuhalten,
wobei die skalierte Version des Spitzenwerts durch die Spannung (VC3) an den Anschlüssen des oben genannten Speicherkondensators (C3) dargestellt ist,
wobei die Entladung des Speicherkondensators (C3) aufgrund des Verhinderns der Funktion des Entlade-Schalters (SW1) verhindert wird.

16. Vorrichtung nach einem der Ansprüche 2 bis 15,
**dadurch gekennzeichnet, dass**
sie Änderungsmittel (SW2, D6) aufweist, die vom Mikrocontroller gesteuert werden, die auf die Schaltungstopologie der Versorgungsschaltung (33) einwirken, um sie im Vollwellen-Gleichrichtungsmodus arbeiten zu lassen.

17. Verfahren zum Messen einer Wechselspannung (U1) einer elektrischen Netzleitung mittels einer Messvorrichtung der galvanisch isolierten Art mit einer Messschaltung (35), die mit einem Mikrocontroller versehen ist, die verbunden ist mit einer Versorgungsschaltung (33) und
einem Transformator (T), der eine Primärwicklung, die mit der Netzsinusspannung (U1) gespeist wird und mit der elektrischen Leitung verbunden ist, und eine Sekundärwicklung, die einer Spannung (U2) ausgesetzt ist, die beide sowohl mit der Messschaltung (35) als auch mit der Versorgungsschaltung (33) verbunden sind, aufweist **dadurch gekennzeichnet, dass**
das Verfahren aufweist:
- einen ersten Schritt, während dem ein erstes Vollwellen-Gleichrichterelement (BRG) der Versorgungsschaltung (33) die Wechselspannung (U2) der Sekundärwicklung in eine erste gleichgerichtete Vollwellen-Spannung (U3) umwandelt,
- einen zweiten Schritt gleichzeitig mit dem ersten Schritt, bei dem ein zweites Vollwellen-Gleichrichterelement (BRG') der Messschaltung (35) die Wechselspannung (U2) der Sekundärwicklung in eine zweite gleichgerichtete Vollwellen-Spannung (U4) umwandelt, wobei das zweite Gleichrichterelement (BRG') keine Lasteffekte auf die Sekundärwicklung des Transformators (T) erzeugt, wobei das Gleichrichterelement (BRG') durch eine hochohmige Impedanz (R') belastet wird, und
- einen dritten Schritt gleichzeitig mit einem Teil des ersten und zweiten Schritts, in dem das erste Gleichrichterelement (BRG) der Versorgungsschaltung (33) keinen Strom leitet und der Mikrocontroller die gedämpfte und abgetastete Version der Wellenform der zweiten gleichgerichteten Vollwellen-Spannung (U4) stromabwärts des zweiten Gleichrichterelements (BRG') der Messschaltung (35) in Zeitintervallen ([w0, w1], [w2, t4]) unabhängig von der Last der Versorgungsschaltung (33) und über zeitgleiche Zeitpunkte (w0, w3) gelegt, in denen die zweite gleichgerichtete Vollwellen-Spannung (U4) verschwindet, auswertet, das heißt in Zeitintervallen, in denen die zweite gleichgerichtete Vollwellen-Spannung (U4) stromabwärts des zweiten Gleichrichterelements (BRG') unabhängig von der Last der Versorgungsschaltung (33) proportional zu der zu messenden Sinusspannung (U1) ist, wobei die Zeitintervalle ([w0, w1], [w2, t4]) in dem nichtflüchtigen Speicher des Mikrocontrollers mittels Konstanten parametrisiert sind, die als eine Funktion des Wertes der Schaltungskomponenten vorbestimmt sind und die Intervalle nicht-leitende Intervalle für den Gleichrichter (BRG) sind, unabhängig vom derzeitigen Wert der Last (R), der für die Versorgungsschaltung (33) zulässig ist.

18. Verfahren zur Messung einer Wechselspannung einer elektrischen Netzleitung mittels einer Messvorrichtung galvanisch isolierter Art mit einer Messschaltung (35), einer Versorgungsschaltung (33) und
einem Transformator (T), der eine Primärwicklung, die mit der Netzsinusspannung (V1) gespeist wird und mit der elektrischen Leitung verbunden ist, und eine Sekundärwicklung, die einer Spannung (V2) ausgesetzt ist, die mit der Messschaltung (35) und mit der Versorgungsschaltung (33) verbunden ist, aufweist
**dadurch gekennzeichnet, dass**
das Verfahren aufweist:
- einen ersten Schritt, bei dem die Versorgungsschaltung (33) vom Halbwellen-Typ ist und die ungeraden Halbperioden (V3) verwendet, um mindestens die Messschaltung (35) zu versorgen, und
- einen zweiten Schritt, zeitlich verschoben zu dem ersten Schritt, in dem die Messschaltung (35) vom Halbwellen-Gleichrichtertyp ist und die Messungen an den geraden Halbperioden (V4) in den relativen Spitzenzeitpunkten (t5, t6) ausführt, in denen Messungen im Wesentlichen unabhängig von den ungeraden Spannungs-Halbperioden (V3) der Versorgungsschaltung (33) sind, das magnetische Hysterese-Phänomen in dem Kern des Transformators (T) aufgrund der vorhergehenden ungeraden Halbperioden der Versorgungsspannung (V3) in den Spitzenzeitpunkten (t5, t6) nahezu nicht mehr existiert, in den Spitzenzeitpunkten (t5, t6) der geraden Halbperioden der Messspannung (V4), der Restspeicher der vorangegangenen ungeraden Halbperioden der Versorgungsspannung (V3) minimal ist, so dass die Spitzenwerte dieser geraden Spannungs-Halbperioden (V4) proportional zu den Spitzenwerten der zu messenden Wechselspannung (V1) sind.

19. Verfahren nach Anspruch 18, **dadurch gekennzeichnet, dass** der zweite Schritt zweite Mittel, beispielsweise eine dritte Diode (D3) und/oder einen Stromverstärker, wie einen Transistor (Q), und eine vierte Diode (D4), die Teil der Messschaltung (35) sind, die am Eingang die Spannung der Sekundärwicklung (V2) des Transformators (T) empfängt und nur die Spannung der geraden Halbperioden (V4) durchlässt.

20. Verfahren nach Anspruch 18 oder 19, **dadurch gekennzeichnet, dass** es einen vierten Schritt aufweist, in dem nach Maßgabe des Mikrocontrollers gesteuerte Änderungsmittel (SW2, D6) auf die Schaltungstopologie einwirken, so dass die Versorgungsschaltung (33) Vollwellen-Gleichrichter arbeitet.

## Revendications

1. Dispositif de mesure, du type à isolation galvanique, pour mesurer une tension alternative (U1) d'une ligne de réseau électrique, comprenant un circuit de mesure (35), ayant un microcontrôleur, un circuit d'alimentation (33) apte à alimenter au moins ledit circuit de mesure (35), et un transformateur (T), ayant un enroulement primaire alimenté par la tension sinusoïdale du réseau (U1), connecté à ladite ligne électrique, et un enroulement secondaire ayant une tension (U2), connecté à la fois audit circuit de mesure (35) et également audit circuit d'alimentation (33), ledit dispositif de mesure étant **caractérisé par le fait que** ledit circuit d'alimentation (33) et ledit circuit de mesure (35) comprennent respectivement un premier et un second élément de redresseur à deux alternances (BRG, BRG'), distincts l'un de l'autre, le second élément de redresseur (BRG') étant configuré de façon à ne pas générer d'effets de charge sur l'enroulement secondaire du transformateur (T), ledit élément de redresseur (BRG') étant chargé avec une impédance de valeur élevée (R'), lesdits premier et second éléments de redresseur (BRG, BRG') étant aptes à convertir la tension alternative (U2) de l'enroulement secondaire du transformateur (T) en première et seconde tensions redressées à deux alternances (U3, U4) respectives, et également **caractérisé par le fait que** ledit circuit de mesure (35) est configuré pour considérer la seconde tension redressée à deux alternances (U4) dans des intervalles de temps ([w0, w1], [w2, w4]) indépendants de la charge du circuit d'alimentation (33) pendant lesquels l'effet de charge du circuit d'alimentation (33) sur l'enroulement secondaire du transformateur (T) est négligeable, c'est-à-dire, dans des intervalles de temps pendant lesquels le premier élément de redresseur (BRG) ne conduit pas, dans lesdits intervalles de temps ([w0, w1], [w2, t4]) ladite seconde tension redressée à deux alternances (U4) étant sensiblement proportionnelle à ladite tension alternative (U1) à mesurer, lesdits intervalles de temps ([w0, w1], [w2, t4]) étant paramétrés dans la mémoire non-volatile du microcontrôleur au moyen de constantes prédéterminées en fonction de la valeur des composants de circuit et lesdits intervalles étant non-conducteurs pour le premier élément de redresseur (BRG) quelle que soit la valeur instantanée de la charge (R) admissible pour le circuit d'alimentation (33).

2. Dispositif de mesure, du type à isolation galvanique, pour mesurer une tension alternative (V1) d'une ligne de réseau électrique, comprenant un circuit de mesure (35), ayant un microcontrôleur, un circuit d'alimentation (33), apte à alimenter au moins ledit circuit de mesure (35), et un transformateur (T), ayant un enroulement primaire alimenté par la tension sinusoïdale du réseau (V1), connecté à ladite ligne électrique, et un enroulement secondaire ayant une tension (V2) connecté à la fois audit circuit de mesure (35) et également audit circuit d'alimentation (33), le dispositif de mesure étant **caractérisé par le fait que** ledit circuit d'alimentation (33) comprend des premiers moyens (D1, D2) configurés pour séparer et isoler les demi-cycles impairs de la tension (V2) présente dans ledit enroulement secondaire dudit transformateur (T) et **caractérisé par le fait que** ledit circuit de mesure (35) comprend des seconds moyens (D3, D4, Q) configurés pour séparer et isoler les demi-cycles pairs de la tension (V2) présente dans ledit enroulement secondaire dudit transformateur (T) de façon à réaliser les mesures de tension, lesdits demi-cycles de tension impairs (V3) étant utilisés pour alimenter ledit circuit de mesure (35) et lesdits demi-cycles de tension pairs (V4) étant utilisés pour mesurer la tension sur le réseau électrique, ledit circuit de mesure (35) étant configuré pour considérer lesdits demi-cycles de tension pairs (V4) dans les instants de crête (t5, t6) relatifs pendant lesquels les tensions de crête sont sensiblement indépendantes des demi-cycles impairs de tension (V3) dudit circuit d'alimentation (33), les phénomènes d'hystérésis magnétique du noyau du transformateur (T), dus aux demi-cycles impairs précédents de la tension d'alimentation (V3), ayant presque disparu dans lesdits instants de crête (t5, t6), étant, dans lesdits instants de crête (t5, t6) des demi-cycles pairs de la tension de mesure (V4), la mémoire résiduelle minimale des demi-cycles impairs précédents de la tension d'alimentation (V3), de telle sorte que les valeurs de crête desdits demi-cycles pairs de tension (V4) sont proportionnelles aux valeurs de crête de ladite tension alternative (V1) à mesurer.

3. Dispositif selon la revendication 2, **caractérisé par le fait que** lesdits premiers moyens (D1, D2) comprennent une première diode (D1) et une deuxième diode (D2), lesdites diodes (D1, D2) étant en harmonie dans la direction de la circulation de courant et connectées respectivement aux bornes dudit enroulement secondaire du transformateur (T), et **par le fait que** lesdits seconds moyens (D3, D4, Q) comprennent un premier dispositif à semi-conducteurs (D3 et/ou Q), connecté directement ou indirectement à la cathode de ladite deuxième diode (D2), et une quatrième diode (D4), dont la cathode est connectée à l'anode de ladite première diode (D1) et dont l'anode est connectée à l'anode de ladite deuxième diode (D2).

4. Dispositif selon la revendication 3, **caractérisé par le fait que** ledit circuit de mesure (35) comprend un diviseur capacitif, ayant la double fonction de stockage de la valeur de crête de la tension de mesure (V4) détectée dans les demi-cycles pairs et de division de la valeur de ladite tension de crête, ayant un premier condensateur (C1) et un deuxième condensateur (C2), connecté en série avec ledit premier condensateur (C1), et le microcontrôleur, apte à réaliser des mesures de tension, ayant son entrée de mesure connectée au moins au noeud commun entre le premier condensateur (C1) et le deuxième condensateur (C2).

5. Dispositif selon la revendication 4, **caractérisé par le fait qu'**il comprend des moyens de décharge (RD, SW1) aptes à décharger automatiquement ledit premier condensateur (C1) et ledit deuxième condensateur (C2) durant au moins un demi-cycle de tension impair.

6. Dispositif selon la revendication 4, **caractérisé par le fait qu'**il comprend des moyens de décharge (RD, SW1) aptes à décharger ledit premier condensateur (C1) et ledit deuxième condensateur (C2) sous la commande dudit microcontrôleur après une mesure réalisée par ledit microcontrôleur.

7. Dispositif selon la revendication 5, **caractérisé par le fait que** lesdits moyens de décharge (RD, SW1) comprennent une résistance de décharge (RD) et un premier commutateur (SW1), connectés l'un à l'autre en série, ladite série étant connectée en parallèle à la série dudit premier condensateur (C1) et dudit deuxième condensateur (C2) et **par le fait que** la fermeture du premier commutateur (SW1) est commandée par un signal provenant de la cathode de ladite quatrième diode (D4).

8. Dispositif selon les revendications 5 et 7, **caractérisé par le fait que** ledit microcontrôleur est apte à empêcher l'action dudit premier commutateur de décharge (SW1) de façon à conserver stockée la valeur de crête de la tension (V4) détectée au cours d'un demi-cycle pair au niveau des bornes dudit premier condensateur (C1) et dudit deuxième condensateur (C2), la décharge desdits condensateurs étant empêchée.

9. Dispositif selon la revendication 3, **caractérisé par le fait que** ledit premier dispositif à semi-conducteurs comprend un amplificateur de courant, tel qu'un transistor (Q), **et par le fait que** le circuit de mesure (35) comprend un diviseur résistif (R1, R2) connecté audit amplificateur de courant apte à charger un troisième condensateur de mémoire (C3), le microcontrôleur étant connecté audit condensateur de mémoire (C3), **et caractérisé par le fait que** ledit condensateur de mémoire (C3) est apte à stocker la version mise à l'échelle par ledit diviseur résistif (R1, R2) de la valeur de crête de la tension de mesure (V4) détectée dans les demi-cycles pairs.

10. Dispositif selon la revendication 9, **caractérisé par le fait qu'**il comprend un second transistor (Q') connecté en série à l'une des deux résistances (R1, R2), apte à compenser la dérive de la tension de jonction base-émetteur dudit transistor d'amplificateur (Q).

11. Dispositif selon la revendication 10, **caractérisé par le fait que** ledit second transistor (Q') est couplé thermiquement audit transistor d'amplificateur (Q) .

12. Dispositif selon les revendications 9, 10 et 11, **caractérisé par le fait qu'**il comprend des moyens de décharge (RD, SW1) aptes à décharger automatiquement ledit troisième condensateur de mémoire (C3) durant au moins un demi-cycle de tension impair.

13. Dispositif selon les revendications 9, 10 et 11, **caractérisé par le fait qu'**il comprend des moyens de décharge (RD, SW1) aptes à décharger ledit condensateur de mémoire (C3) et commandés directement par ledit microcontrôleur après une mesure réalisée par ledit microcontrôleur.

14. Dispositif selon la revendication 12, **caractérisé par le fait que** lesdits moyens de décharge (RD, SW1) comprennent une résistance de décharge (RD) et un premier commutateur (SW1), connectés l'un à l'autre en série, ladite série étant connectée en parallèle audit condensateur de mémoire (C3), et **par le fait que** la fermeture dudit premier commutateur (SW1) est commandée par un signal provenant de la cathode de ladite quatrième diode (D4) .

15. Dispositif selon les revendications 12 et 14, **caractérisé par le fait que** ledit microcontrôleur est apte à empêcher l'action dudit premier commutateur de décharge (SW1) de façon à conserver en mémoire la version mise à l'échelle par ledit diviseur résistif (R1, R2) de la valeur de crête de la tension de mesure (4) détectée dans les demi-cycles pairs, ladite version mise à l'échelle de la valeur de crête étant représentée par la tension (VC3) au niveau des bornes du condensateur de mémoire (C3) mentionné ci-dessus, la décharge dudit condensateur de mémoire (C3) étant empêchée en raison de l'empêchement de l'action dudit commutateur de décharge (SW1).

16. Dispositif selon l'une quelconque des revendications 2 à 15, **caractérisé par le fait qu'**il comprend des moyens de changement (SW2, D6), commandés par le microcontrôleur, agissant sur la topologie de circuit dudit circuit d'alimentation (33) de façon à la faire fonctionner dans un mode de redressement à deux alternances.

17. Procédé de mesure d'une tension alternative (U1) d'une ligne de réseau électrique au moyen d'un dispositif de mesure du type à isolation galvanique, ayant un circuit de mesure (35), comportant un microcontrôleur, associé à un circuit d'alimentation (33) et à un transformateur (T), comportant un enroulement primaire, alimenté par la tension sinusoïdale du réseau (U1) et connecté à ladite ligne électrique, et un enroulement secondaire soumis à une tension (U2), connecté à la fois audit circuit de mesure (35) et également audit circuit d'alimentation (33), **caractérisé par le fait que** ledit procédé comprend :
- une première étape durant laquelle un premier élément de redresseur à deux alternances (BRG) dudit circuit d'alimentation (33) convertit la tension alternative (U2) dudit enroulement secondaire en une première tension redressée à deux alternances (U3),
- une deuxième étape, simultanée avec la première étape, dans laquelle un second élément de redresseur à deux alternances (BRG') dudit circuit de mesure (35) convertit la tension alternative (U2) dudit enroulement secondaire en une seconde tension redressée à deux alternances (U4), ledit second élément de redresseur (BRG') ne générant pas d'effets de charge sur l'enroulement secondaire du transformateur (T), ledit élément de redresseur (BRG') étant chargé par une impédance de valeur élevée (R'), et
- une troisième étape, simultanée avec une partie des première et deuxième étapes, dans laquelle ledit premier élément de redresseur (BRG) dudit circuit d'alimentation (33) ne conduit pas le courant et ledit microcontrôleur évalue la version atténuée et échantillonnée de ladite forme d'onde de la seconde tension redressée à deux alternances (U4) en aval dudit second élément de redresseur (BRG') dudit circuit de mesure (35) à des intervalles de temps ([w0, w1], [w2, t4]) indépendants de la charge du circuit d'alimentation (33) et placés à travers des instants mis en correspondance (w0, w3) pendant lesquels la seconde tension redressée à deux alternances (U4) disparaît, c'est-à-dire, dans des intervalles de temps pendant lesquels ladite seconde tension redressée à deux alternances (U4) en aval dudit second élément de redresseur (BRG'), indépendamment de la charge du circuit d'alimentation (33), est proportionnelle à ladite tension sinusoïdale (U1) à mesurer, lesdits intervalles de temps ([w0, w1], [w2, t4]) étant paramétrés dans la mémoire non-volatile du microcontrôleur au moyen de constantes prédéterminées en fonction de la valeur des composants de circuit et lesdits intervalles étant des intervalles non-conducteurs pour le redresseur (BRG) quelle que soit la valeur instantanée de la charge (R) admissible pour le circuit d'alimentation (33).

18. Procédé de mesure d'une tension alternative d'une ligne de réseau électrique au moyen d'un dispositif de mesure du type à isolation galvanique, ayant un circuit de mesure (35), un circuit d'alimentation (33) et un transformateur (T), comportant un enroulement primaire, alimenté par la tension sinusoïdale du réseau (V1), connecté à ladite ligne électrique, et un enroulement secondaire soumis à une tension (V2), connecté audit circuit de mesure (35) et audit circuit d'alimentation (33), **caractérisé par le fait que** ledit procédé fournit :
- une première étape dans laquelle ledit circuit d'alimentation (33) est du type à simple alternance et utilise les demi-cycles impairs de tension (V3) pour alimenter au moins ledit circuit de mesure (35), et
- une deuxième étape, alternée temporellement avec la première étape, dans laquelle ledit circuit de mesure (35) est du type redresseur à simple alternance et réalise les mesures sur les demi-cycles pairs de tension (V4), dans les instants de crête (t5, t6) relatifs pendant lesquels lesdites mesures sont sensiblement indépendantes des demi-cycles impairs de tension (V3) dudit circuit d'alimentation (33), les phénomènes d'hystérésis magnétique dans le noyau du transformateur (T), pouvant être attribués aux demi-cycles impairs précédents de la tension d'alimentation (V3), ayant presque disparu dans lesdits instants de crête (t5, t6), étant, dans lesdits instants de crête (t5, t6) des demi-cycles pairs de la tension de mesure (V4), une mémoire résiduelle minimale des demi-cycles impairs précédents de la tension d'alimentation (V3), de telle sorte que les valeurs de crête desdits demi-cycles pairs de tension (V4) sont proportionnelles aux valeurs de crête de ladite tension alternative (V1) à mesurer.

19. Procédé selon la revendication 18, **caractérisé par le fait que** ladite deuxième étape fournit des seconds moyens, par exemple une troisième diode (D3) et/ou un amplificateur de courant, tel qu'un transistor (Q), et une quatrième diode (D4), qui font partie du circuit de mesure (35), qui reçoivent en entrée la tension de l'enroulement secondaire (V2) dudit transformateur (T) et permettent de faire passer uniquement les simples alternances paires de tension (V4).

20. Procédé selon la revendication 18 ou 19, **caractérisé par le fait qu'**il comprend une quatrième étape dans laquelle des moyens de changement (SW2, D6), commandés à la discrétion du microcontrôleur, agissent sur la topologie de circuit de telle sorte que le circuit d'alimentation (33) fonctionne comme un redresseur à deux alternances.
